# EUROPEAN PATENT APPLICATION

(11) **EP 4 432 563 A1**
(43) Date of publication of application: **18.09.2024**
(21) Application number: 23162661.5
(22) Date of filing: 17.03.2023
(51) Int. Cl.: H03K 17/12, H03K 17/16, H03K 17/723

(54) **SWITCHING ASSEMBLY WITH A FIRST TRANSISTOR AND A SECOND TRANSISTOR RECEIVING A COMMON GATE SIGNAL**

(71) Applicant: Infineon Technologies AG, 85579 Neubiberg (DE)
(72) Inventor: DOMES, Daniel, 59457 Werl (DE)
(74) Representative: Müller Hoffmann & Partner

(57) **Abstract**

A switching assembly (900) includes a common gate structure (GC). A first transistor (110) includes a first gate terminal (G1). A second transistor (120) includes a second gate terminal (G2). A first coil (211) is electrically connected between the first gate terminal (G1) and the common gate structure (GC). A second coil (212) is electrically connected between the second gate terminal (G2) and the common gate structure (GC). The first coil (211) and the second coil (212) are inversely inductively coupled with reference to a current supplied through the common gate structure (GC).

## Description

### TECHNICAL FIELD

Examples of the preset disclosure relate to a switching assembly that includes a first transistor and a second transistor. In particular, the present disclosure relates to switching assemblies including at least two transistors controlled through a gate signal supplied through a common gate structure.

### BACKGROUND

Power semiconductor assemblies have to cope with increasingly higher current densities. Depending on the conditions of a particular application, it may sometimes be more advantageous to connect several power semiconductor devices with lower current-carrying capacity in parallel than to use a single power semiconductor device with high current-carrying capacity. The parallel connection of several power semiconductor devices forms a number of electrical loops. The combination of device-specific characteristics and a circuit environment afflicted with parasitic inductances and parasitic capacitances can cause high-frequency oscillations in any electrical loop during switching operations, as well as during a short circuit. The high-frequency oscillations can increase power consumption, cause the power semiconductor assembly to malfunction, and/or destroy components of the power semiconductor assembly.

To prevent the occurrence of high-frequency oscillations at relevant operating points, elaborate measures are usually taken at the layout level.

There is a constant need to further improve the functionality of switching assemblies with little additional effort.

### SUMMARY

Embodiments of the present disclosure relate to a switching assembly that includes a common gate structure, a first transistor that includes a first gate terminal, a second transistor that includes a second gate terminal, a first coil electrically connected between the first gate terminal and the common gate structure, and a second coil electrically connected between the second gate terminal and the common gate structure. The first coil and the second coil are inversely inductively coupled with reference to a current supplied through the common gate structure.

When a gate signal is supplied to the first and second gate terminals through the common gate structure GC, a first magnetic flux induced by a current flowing from the common gate structure to the first gate terminal and a second magnetic flux induced by a current flowing from the common gate terminal to the second gate terminal have opposite directions and compensate each other at least partly. The first coil and the second coil have little or no effect on the switching performance of the switching assembly.

When an oscillation is excited in an electrical loop that includes the first transistor and the second transistor, a circle current exiting from the first gate terminal flows into the second gate terminal or vice versa. The circle current passes the first coil and the second coil in opposite directions. For the circle current, the first coil and the second coil are "not-inversely" inductively coupled. A first dynamic magnetic flux generated by the current flowing through the first coil and a second dynamic magnetic flux generated by the current flowing through the second coil are in phase and add up. The resulting comparatively high total coil inductance can detune the parasitic oscillating system and prevent the potential oscillating system from oscillating.

Those skilled in the art will recognize additional features and advantages upon reading the following detailed description and on viewing the accompanying drawings.

### BRIEF DESCRIPTION OF THE DRAWINGS

The accompanying drawings are included to provide a further understanding of the embodiments and are incorporated in and constitute a part of this specification. The drawings illustrate embodiments of a switching assembly and together with the description serve to explain principles of the embodiments. Further embodiments are described in the following detailed description and the claims. Features of the various illustrated embodiments may be combined with each other.
FIG. 1 is a schematic circuit diagram of a portion of a switching assembly with inversely inductively coupled coils in gate input paths of a first transistor and a second transistor in accordance with an embodiment.
FIG. 2 is a schematic diagram of a transformer including windings of two inversely inductively coupled coils in accordance with an embodiment.
FIG. 3 is a schematic circuit diagram of a portion of a switching assembly with more than two transistors and with inversely inductively coupled coils in gate input paths of two of the transistors in accordance with an embodiment.
FIG. 4 is a schematic circuit diagram of a portion of a switching assembly with two sets of inversely inductively coupled coils in gate input paths of three transistors in accordance with an embodiment.
FIG. 5 is a schematic diagram of a transformer including windings for one the two sets of inversely inductively coupled coils for the switching assembly of FIG. 4 in accordance with an embodiment.
FIG. 6 is a schematic circuit diagram of a portion of a switching assembly with three coils including windings wound around different legs of a three-leg transformer core in accordance with an embodiment.
FIG. 7 is a schematic circuit diagram of a portion of a switching assembly with pairs of inversely inductively coupled coils in gate input paths of four transistors in accordance with an embodiment.
FIG. 8 is a schematic circuit diagram of a portion of a switching assembly with pairs of inversely inductively coupled coils in gate input paths of four transistors and another pair of inversely inductively coupled coils in a common gate signal path in accordance with an embodiment.
FIG. 9 is a schematic perspective view of a switching assembly with inversely inductively coupled coils mounted or formed on a carrier substrate in accordance with an embodiment.
FIG. 10 is a schematic block diagram of a switching assembly with inversely inductively coupled coils in a common gate input path of two semiconductor switching modules that include transistors of the same transistor type in accordance with an embodiment.
FIG. 11 is a schematic block diagram of a switching assembly with inversely inductively coupled coils in a common gate input path of two semiconductor switching modules that include transistors of different transistor types in accordance with another embodiment.
FIG. 12 is a schematic top view of a coreless transformer with a pair of inversely inductively coupled coils in accordance with an embodiment with windings of the coils partly formed of bonding wires.

### DETAILED DESCRIPTION

In the following detailed description, reference is made to the accompanying drawings, which form a part hereof and in which are shown by way of illustrations specific embodiments in which a switching assembly may be practiced. Other embodiments may be utilized, and structural or logical changes may be made without departing from the scope of the present disclosure. For example, features illustrated or described for one embodiment can be used on or in conjunction with other embodiments to yield yet a further embodiment. It is intended that the present disclosure includes such modifications and variations. The examples are described using specific language, which should not be construed as limiting the scope of the appending claims. The drawings are not scaled and are for illustrative purposes only. Corresponding elements are designated by the same reference signs in the different drawings if not stated otherwise.

The terms "having", "containing", "including", "comprising" and the like are open, and the terms indicate the presence of stated structures, elements or features but do not preclude the presence of additional elements or features. The articles "a", "an" and "the" are intended to include the plural as well as the singular, unless the context clearly indicates otherwise.

The term "directly electrically connected" describes a permanent low-resistive ohmic connection between the directly electrically connected elements, for example a direct contact between the concerned elements or a low-resistive connection via a metal and/or heavily doped semiconductor material. The terms "electrically connected" and "signal connected" include a direct electrical connection and additionally allow for other electrical elements in a signal path or power supply path between the electrically connected or signal connected elements.

The term "power semiconductor device" refers to semiconductor devices with a high voltage blocking capability of at least 30 V, for example 48 V, 100 V, 600 V, 1.6 kV, 3.3 kV or more and with a nominal on-state current or forward current of at least 200 mA, for example 1 A, 10 A or more.

Ranges given for physical dimensions include the boundary values. For example, a range for a parameter y from a to b reads as a ≤ y ≤ b. The same holds for ranges with one boundary value like "at most" and "at least".

The Figures use the dot convention to specify the direction of windings of inductively coupled coils. Each dot marks an end of a winding. If both currents enter the dotted ends of the coupled coils or if both currents enter undotted ends, then the sign of mutual inductance will be same as the signs of the self-inductance.

The present disclosure concerns a switching assembly that may include a common gate structure, a first transistor, a second transistor, a first coil, and a second coil. The first transistor includes a first gate terminal. The second transistor includes a second gate terminal. The first coil may be electrically connected between the first gate terminal and the common gate structure. The second coil may be electrically connected between the second gate terminal and the common gate structure. The first coil and the second coil may be inversely inductively coupled with reference to a current supplied through the common gate structure.

Controlled load paths of the transistors may be electrically connected in parallel. The switching assembly may include more than two transistors receiving a gate signal from the same gate signal source through the common gate structure. The transistors may switch in phase or approximately in phase. This means, for example, that the transistors are controlled to switch from a conductive state to a non-conductive state or vice versa by the same gate signal. Due to manufacturing variations of the transistors, a layout of the switching assembly and/or conditions depending on the operating environment of the switching assembly, a turn-on or turn-off switching behavior of the two transistors may slightly deviate from each other.

The switching assembly may include power semiconductor transistors based on the same semiconductor material or transistors based on different semiconductor materials. Each transistor may be a silicon device, a gallium nitride device, or a silicon carbide device.

The switching assembly may include transistors of different transistor types or of the same transistor type. Each transistor may be a junction field effect transistor (JFET), an insulated gate bipolar transistor (IGBT), a high electron mobility transistor (HEMT), or an insulated gate field effect transistor (IGFET) such as a metal oxide semiconductor field effect transistor (MOSFET). In case a transistor is a bipolar junction transistor (BJT), the mentioned gate terminal is to be understood as the base terminal of the BJT.

The common gate structure may be or include a gate terminal of a semiconductor die, a gate pin of a transistor package, a connector block of a power module, or a solder pad of a power module.

The first coil (first inductor) and the second coil (second inductor) may be directly electrically connected to the common gate structure with no further inductive element between the first coil and the common gate structure and with no further inductive element between the second coil and the common gate structure. Alternatively, a further coil may be electrically connected between the common gate structure and a network node connected to the first and second coil.

The first coil includes a first winding with one first turn or a plurality of first turns. The second coil includes a second winding with one second turn or a plurality of second turns. An inductive coupling coefficient between the first winding and the second winding is greater than 0.1, e.g., greater than 0.5 or greater than 0.9.

The first winding and the second winding are inversely magnetically coupled with respect to a current supplied, i.e., sourced or sunk through the common gate structure GC and distributed to the first gate terminal G1 and the second gate terminal G2 to simultaneously turn on the first and second transistor or to simultaneously turn off the first and second transistor. A first magnetic flux induced by a current flowing from the common gate structure to the first gate terminal and a second magnetic flux induced by a current flowing from the common gate structure to the second gate terminal have opposite directions.

When a gate signal is supplied to the first and second gate terminals through the common gate structure, the first magnetic flux induced by a current flowing from the common gate structure to the first gate terminal and the second magnetic flux induced by a current flowing from the common gate terminal to the second gate terminal have opposite directions and compensate each other at least partly. The influence of the coil inductivities on a current for charging and discharging the first and second gate capacitances associated with the respective gates and for turning on and turning off the first and second transistors is small. The first coil and the second coil have little or no effect on the switching performance of the switching assembly.

The first transistor and the second transistor are parts of an electrical loop that can form a parasitic oscillating system.

Switching operations and short circuit conditions can excite oscillations with frequencies in the range of several hundred MHz in the parasitic oscillating system. When such an oscillation is excited, a circle current exiting from the first gate terminal flows into the second gate terminal or vice versa. The circle current passes the first coil and the second coil in opposite directions. For the circle current, the first coil and the second coil are "non-inversely" inductively coupled. A first dynamic magnetic flux generated by the current flowing through the first coil and a second dynamic magnetic flux generated by the current flowing through the second coil are in phase and add up. The total coil inductivity can be sufficiently high to significantly detune the parasitic oscillating system and prevent the potential oscillating system formed by the electrical loop including the first transistor and the second transistor from oscillating.

According to an embodiment the switching assembly may further include a transformer core. The first coil and the second coil may be wound around the transformer core in opposite winding directions.

For example, the first winding is wound clockwise around the transformer core and the second winding is wound counterclockwise around the transformer core. The shape of the transformer core may be a bar, a cylinder, a closed rectangular frame, or a torus, by way of example.

According to an embodiment, the switching assembly may further include a third transistor including a third gate terminal that receives a gate signal through the common gate structure.

According to an embodiment of a switching assembly with a third transistor including a third gate terminal that receives a gate signal through the common gate structure, the switching assembly may further include a first auxiliary coil that may be electrically connected between the third gate terminal and the common gate structure. The first auxiliary coil may be inductively coupled with a first gate current flowing between the common gate structure and the first gate terminal and with a second gate current flowing between the common gate structure and the second gate terminal.

In other words, a current through the first auxiliary coil is inductively coupled with a first gate current flowing between the common gate structure and the first gate terminal and with a second gate current flowing between the common gate structure and the second gate terminal.

The first auxiliary coil offers the opportunity to detune, in addition to the parasitic oscillation system formed by the electrical loop through the first coil 211, the first transistor 110, the second transistor 120 and the second coil 212, at least one further parasitic oscillation system that includes the third transistor 130.

According to another embodiment of a switching assembly with a third transistor including a third gate terminal that receives a gate signal through the common gate structure, the switching assembly may further include an auxiliary transformer. The auxiliary transformer may include a first auxiliary coil and a second auxiliary coil. The first auxiliary coil is electrically connected between the third gate terminal and the common gate structure. The second auxiliary coil is electrically connected between the common gate structure and the first and second coils. The first auxiliary coil and the second auxiliary coil are inversely inductively coupled with reference to a current supplied through the common gate structure.

The auxiliary transformer may be coreless. Alternatively, the first auxiliary coil and the second auxiliary coil are wound around an auxiliary transformer core. The auxiliary transformer can attenuate oscillations with frequencies in a range above 10MHz, in particular in a range between 100MHz and 500MHz in a parasitic oscillating system with a circle current flowing through the third transistor and one or both of the first and second transistors.

According to an embodiment, a winding ratio between the first auxiliary coil and the second auxiliary coil can be in a range from 1,9:1 to 2,1:1.

If the first transistor, the second transistor and the third transistor are of the same type and have the same specifications, the gate capacitances will be approximately equal except for manufacturing tolerances. Accordingly, the gate currents for charging of discharging the respective gate will be at least approximately equal. Accordingly, the current through the second auxiliary coil can be about twice the current through the first auxiliary coil. A winding ratio of about 2:1 compensates the difference in currents, and the magnetic fluxes generated by the gate current through the first auxiliary coil and by the gate currents through the second auxiliary coil are at least approximately equal in magnitude.

According to another embodiment of a switching assembly with a third transistor including a third gate terminal that receives a gate signal through the common gate structure, the switching assembly includes a first auxiliary coil electrically connected between the third gate terminal and the common gate structure. A multi-leg transformer core inversely inductively couples the first auxiliary coil with a first gate current flowing between the common gate structure and the first gate terminal and with a second gate current flowing between the common gate structure and the second gate terminal.

Each of the first, second and third coil may be wound around one of the legs of the multi-leg transformer core. The winding directions of the windings of the first, second and third coil are selected such that a magnetic flux generated in any of the legs by a current flowing e.g. from the common gate structure to the respective gate terminal through the windings not wound around the respective leg is opposite to a magnetic flux generated by a current flowing through these windings e.g. from the common gate structure to the dedicated gate structures.

According to a further embodiment of a switching assembly with a third transistor including a third gate terminal that receives a gate signal through the common gate structure, the switching assembly includes a multi-leg transformer core that includes at least a first leg, a second leg, and a third leg. The first coil is wound around the first leg. The second coil may be wound around the second leg. A first auxiliary coil may be wound around the third leg. The coils of each pair of the first coil, the second coil, and the third coil are inversely inductively coupled to each other with reference to a current supplied through the common gate structure.

The number of transistors of the switching assembly may be any number greater two, wherein the number of transistors may be odd or even. The number of legs of the multi-leg transformer core can be equal to the number of transistors. The number of coils can be equal to the number of transistors.

According to another embodiment, the switching assembly further includes a third transistor including a third gate terminal and a fourth transistor including a fourth gate terminal. A third coil may be electrically connected between the third gate terminal and the common gate structure. A fourth coil may be electrically connected between the fourth gate terminal and the common gate structure. The third coil and the fourth coil can be inversely inductively coupled with reference to a current supplied through the common gate structure.

The third coil and the fourth coil may form a coreless transformer. Alternatively, the third coil and the fourth coil can be wound around a second transformer core.

According to a further embodiment, the switching assembly includes a fifth coil and a sixth coil. The fifth coil may be electrically connected between the common gate structure and a first network node connected to the first coil and the second coil. The sixth coil may be electrically connected between the common gate structure and a second network node connected to the third coil and the fourth coil. The fifth coil and the sixth coil may be inversely inductively coupled with reference to a current supplied through the common gate structure.

The fifth coil and the sixth coil may form a coreless transformer. Alternatively, the fifth coil and the sixth coil can be wound around a pre-stage transformer core in opposite winding directions.

According to an embodiment, the switching assembly further includes a first carrier substrate. The first transistor and the second transistor may be mounted on the first carrier substrate.

The first carrier substrate may be a printed circuit board (PCB) or a direct bonded copper (DBC) substrate. The first transistor and the second transistor may be the only power semiconductor switches formed on the first carrier substrate.

According to an embodiment, the first coil and the second coil may be mounted on the first carrier substrate and/or include at least one turn formed by conductor lines in a wiring plane of the first carrier substrate.

The oscillation-attenuating transformer including the first coil, the second coil, and, if applicable, a transformer core and/or further coils may be mounted directly on the first carrier substrate. Alternatively, each of the first coil and the second coil may include conductor loops formed in wiring planes or other metallization planes of the first carrier substrate.

According to an embodiment, the switching assembly further includes a second carrier substrate. The first transistor may be mounted on the first carrier substrate and the second transistor may be mounted on the second carrier substrate.

One or more further transistors with controlled load paths in parallel to the controlled load path of the first transistor may be mounted on the first carrier substrate. One or more further transistors with controlled load paths in parallel to the controlled load path of the second transistor may be mounted on the second carrier substrate. The transformer including the first coil and the second coil can attenuate oscillations in a parasitic oscillating system that is formed by one or more of the gate loops on the first carrier substrate in combination with one or more of the gate loops on the second carrier substrate.

According to an embodiment the first coil and the second coil may be mounted on an auxiliary substrate.

The auxiliary substrate can be separated from the first carrier substrate and the second carrier substrate. The auxiliary substrate may include pins for connecting the auxiliary substrate mechanically and/or electrically with another substrate, e.g., the first carrier substrate or the second carrier substrate. Alternatively, the auxiliary substrate may include bonding pads adapted for wire bonding. The switching assembly may further include a gate driver circuit. The gate driver circuit may be mounted on the auxiliary substrate.

According to an embodiment at least the first coil includes at least one section formed by a bonding wire.

For example, the winding of the first coil includes several turns, and each turn includes a first section formed by a conductor line and a second section formed by a bonding wire.

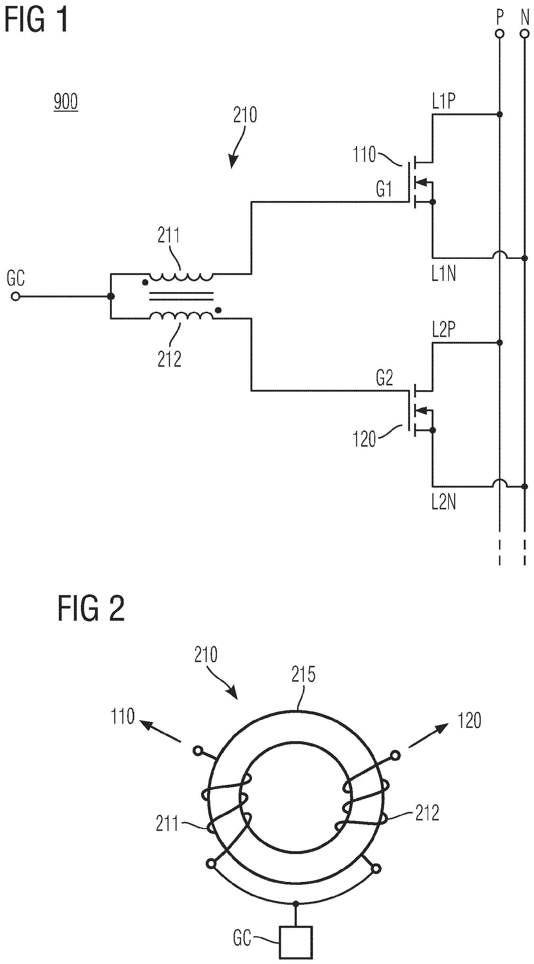

FIG. 1 shows a switching assembly 900 with a common gate structure GC. A first transistor 110 includes a first gate terminal G1. A second transistor 120 includes a second gate terminal G2. A first coil 211 is electrically connected between the first gate terminal G1 and the common gate structure GC. A second coil 212 is electrically connected between the second gate terminal G2 and the common gate structure GC. The first coil 211 and the second coil 212 are inversely inductively coupled with reference to a current supplied through the common gate structure GC.

Controlled load paths of the first transistor 110 and the second transistor 120 are electrically connected in parallel. A positive load terminal L1P of the first transistor 110 and a positive load terminal L2P of the second transistor 120 are directly electrically connected. A negative load terminal L1N of the first transistor 110 and a negative load terminal L2N of the second transistor 120 are directly electrically connected.

Through the common gate structure GC, the first transistor 110 and the second transistor 120 receive a gate signal from the same gate signal source. The first transistor 110 and the second transistor 120 switch in phase or approximately in phase.

In the illustrated embodiment, the first transistor 110 and the second transistor 120 are silicon MOSFETs or silicon carbide MOSFETs.

The common gate structure GC may be or include a gate terminal of a semiconductor die, a gate pin of a transistor package, a connector block of a power module, or a solder pad of a power module.

The first coil 211 includes a first winding with a plurality of turns. A first end of the first winding is directly electrically connected to the common gate structure GC. A second end of the first winding is directly electrically connected to the first gate terminal G1 of the first transistor 110. Alternatively, a first gate resistor may be electrically connected between the second end of the first winding and the first gate terminal G1.

The second coil 212 includes a second winding with a plurality of turns. A first end of the second winding is directly electrically connected to the common gate structure GC. A second end of the second winding is directly electrically connected to the second gate terminal G2 of the second transistor 120. Alternatively, a second gate resistor may be electrically connected between the second end of the second winding and the second gate terminal G2.

An inductive coupling coefficient between the first winding and the second winding is greater than 0.5, e.g., greater than 0.8 or greater than 0.9.

The first winding and the second winding are inversely magnetically coupled with respect to a current sourced or sunk through the common gate structure GC to simultaneously turn on the first and second transistors 110, 120 or to simultaneously turn off the first and second transistors 110, 120. A first magnetic flux induced by a current flowing from the common gate structure GC to the first gate terminal G1 and a second magnetic flux induced by a current flowing from the common gate structure GC to the second gate terminal G2 have opposite directions.

A magnitude (amount) of the first magnetic flux and a magnitude (amount) of the second magnetic flux may be in a same order of magnitude. For example, the magnitude of the second magnetic flux is in a range from 90% to 110%, from 95% to 105% or from 99% to 101% of the magnitude of the first magnetic flux.

When a gate signal is supplied to the first and second gate terminals G1, G2 through the common gate structure GC, the first magnetic flux induced by a current flowing from the common gate structure GC to the first gate terminal G1 and the second magnetic flux induced by a current flowing from the common gate terminal GC to the second gate terminal G2 have opposite directions and compensate each other at least partly. The influence of the coil inductivities on charging and discharging the first and second gate terminals G1 and G2 for turning on and turning off the first and second transistors 110, 120 is small. The first coil 211 and the second coil 212 have little or no effect on the switching performance of the switching assembly 900.

A path in the first transistor 110 between the first gate terminal G1 and the negative load terminal L1N of the first transistor 110, a part of a first load connector N connecting the negative load terminal L1N of the first transistor 110 and the negative load terminal L2N of the second transistor 120, a path in the second transistor 120 between the negative load terminal L2N and the second gate terminal G2, and connection lines connecting the second gate terminal G2 and the first gate terminal G1 form an electrical loop that can form a parasitic oscillating system.

Switching operations and short circuit conditions can excite oscillations with frequencies in the range of several hundred MHz in the parasitic oscillating system. When such an oscillation is excited, a circle current exiting from the first gate terminal G1 flows into the second gate terminal G2 or vice versa. The circle current passes the first coil 211 and the second coil 212 in opposite directions. For the circle current, the first coil 211 and the second coil 212 are "not-inversely" inductively coupled. A first dynamic magnetic flux generated by the current flowing through the first coil 211 and a second dynamic magnetic flux generated by the current flowing through the second coil 212 are in phase and add up. The total coil inductivity can be sufficiently high to significantly detune the parasitic oscillating system and prevent the potential oscillating system formed by the above described first electric loop from oscillating.

The first winding of the first coil 211 and the second winding of the second coil 212 are parts of a (first) transformer 210. The transformer 210 may be a coreless transformer or a transformer with a magnetic core.

In case the transformer 210 is a coreless transformer, the first winding and the second winding can be wound coaxially around the same volume, wherein the first winding is wound clockwise, and the second winding is wound counter-clockwise, or wherein the first winding is wound counter-clockwise and the second winding is wound clockwise, wherein the currents through the first winding and the second winding flow in the same axial direction. Alternatively, the first winding and the second winding can be wound coaxially around the same volume, wherein the first winding and the second winding have the same winding directions and the currents through the first winding and the second winding flow in opposite axial directions.

In FIG. 2 the first coil 211 and the second coil 212 are wound around a (first) transformer core 215 having the shape of a torus. The winding of the first coil 211 and the winding of the second coil 212 are wound around the transformer core 215 in opposite winding directions.

The first coil 211, the second coil 212, and the transformer core 215 form a transformer 210 for attenuating oscillations with frequencies in a range above 10MHz, in particular, in a range between 100MHz and 500MHz.

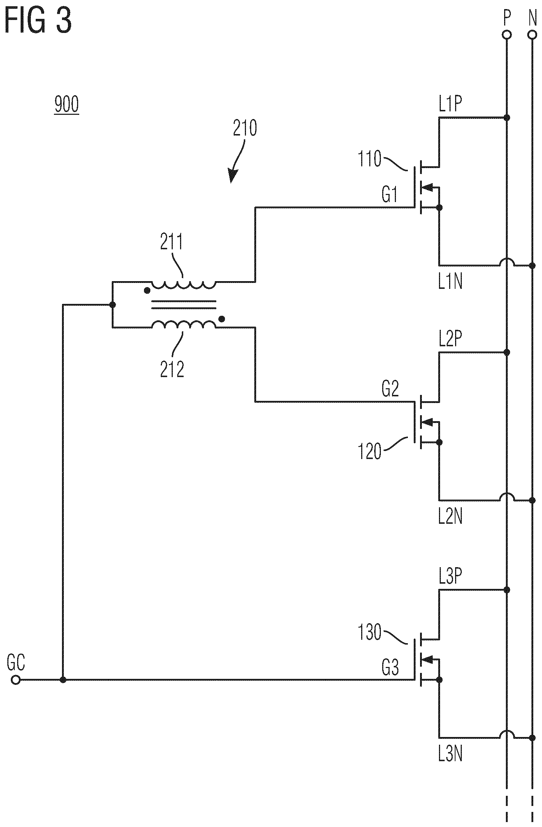

FIG. 3, FIG. 4, and FIG. 6 illustrate switching assemblies 900 with a third transistor 130 including a third gate terminal G3 to receive a gate signal through the common gate structure GC.

The first transistor 110, the second transistor 120, and the third transistor 130 receive the gate signal from the same gate signal source. Controlled load paths of the three transistors 110, 120, 130 are electrically connected in parallel between a first load conductor N and a second load conductor P. The three transistors 110, 120, 130 switch in phase or approximately in phase.

In FIG. 3, the third transistor 130 is directly electrically connected to the common gate structure GC without any inductive element in the path between the common gate structure GC and the third gate terminal G3. Whether the third transistor 130 forms part of a parasitic oscillating system depends on details of the device characteristics of the elements of the switching assembly 900 and on the parasitic inductivities and capacitances of the layout and wiring of the switching assembly 900. The illustrated embodiment relates to an embodiment in which the third transistor 130 is operated without additional, non-parasitic inductivity in the gate loop.

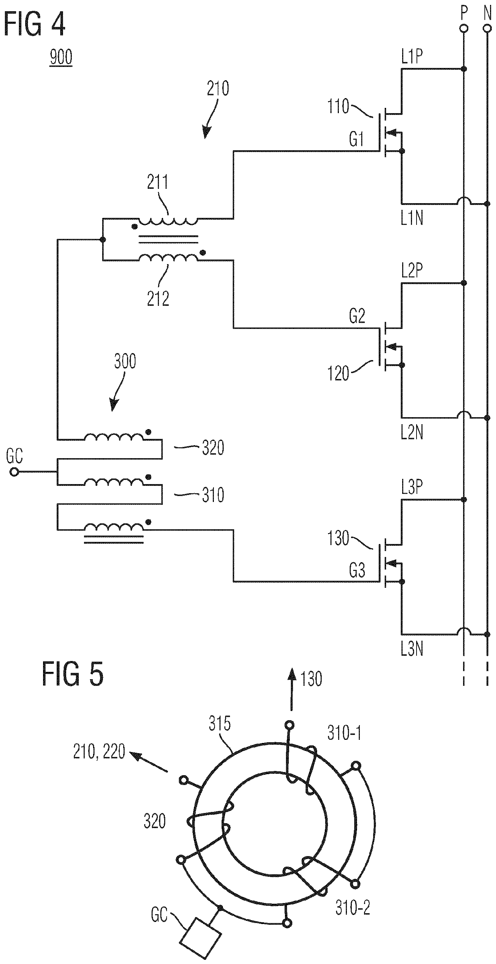

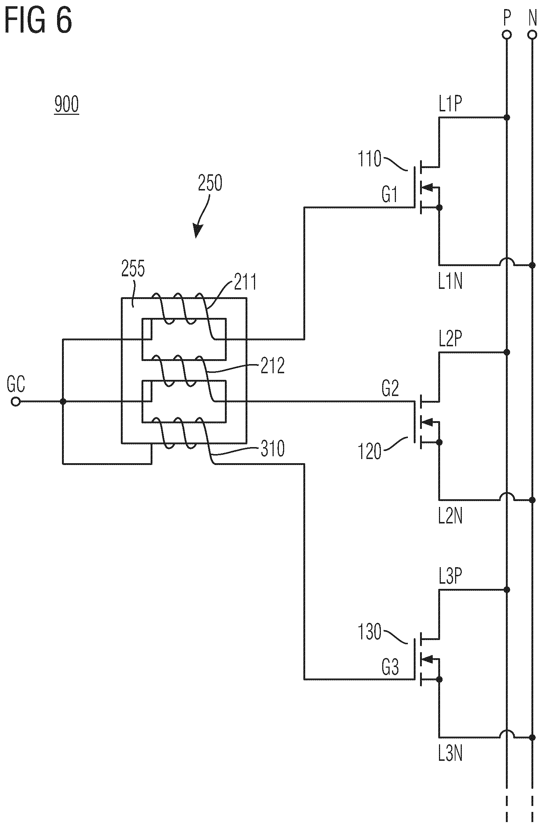

Each of the switching assemblies in FIG. 4 and FIG. 6 includes a first auxiliary coil 310 electrically connected between the third gate terminal G3 and the common gate structure GC. The first auxiliary coil 310 may be inductively coupled with a first gate current flowing between the common gate structure GC and the first gate terminal G1 and with a second gate current flowing between the common gate structure GC and the second gate terminal G2.

The first auxiliary coil 310 and the coupling between the first auxiliary coil 310 and the first and second gate currents can be designed such that a magnetic flux caused by a third gate current for the third transistor 130 is fully compensated or at least nearly completely compensated by the magnetic fluxes generated by the first gate current and the second gate current.

With the first auxiliary coil 310 it is possible to detune, in addition to the parasitic oscillation system formed by the first electric loop, at least one further parasitic oscillation system that includes the third transistor 130.

FIG. 4 shows a switching assembly 900 that includes an additional auxiliary transformer 300 that include a first auxiliary coil 310 and a second auxiliary coil 320. The first auxiliary coil 310 is electrically connected between the common gate structure GC and the third gate terminal G3. The second auxiliary coil 320 is electrically connected between the common gate structure GC and the first and second coils 110, 120.

The first auxiliary coil 310 and the second auxiliary coil 320 are inversely inductively coupled with reference to a current sourced or sunk through the common gate structure GC. For example, the first auxiliary coil 310 and the second auxiliary coil 320 are wound around an auxiliary transformer coil in opposite winding directions.

The auxiliary transformer 300 attenuates oscillations with frequencies in a range above 10MHz, in particular in a range between 100MHz and 500MHz in a parasitic oscillating system with a circle current flowing through the third transistor 130 and one or both of the first and second transistors 110, 120.

FIG. 5 shows an auxiliary transformer 300 that includes an auxiliary transformer core 315 having the shape of a torus. The winding direction of a winding of the first auxiliary coil 310 is opposite to the winding direction of a winding of the second auxiliary coil 320. A winding ratio between the winding of the first auxiliary coil 310 and the winding of the second auxiliary coil 320 is close to 2:1, e.g., in a range from 1,9:1 to 2,1:1. The first auxiliary coil 310 may include two sections 310-1, 310-2 electrically connected in series, wherein each section 310-1, 310-2 has the same number of turns as the second auxiliary coil 320.

The first transistor 110, the second transistor 120 and the third transistor 130 are of the same type and have the same specifications. The gate capacitances of the first transistor 110, the second transistor 120 and the third transistor 130 are approximately equal. The gate currents of the first transistor 110, the second transistor 120 and the third transistor 130 are at least approximately equal. Accordingly, the total current through the second auxiliary coil 320 when the transistors 110, 120, 130 are turned on or off is about twice the current through the first auxiliary coil 310.

A winding ratio of about 2:1 compensates the difference in currents such that the magnetic fluxes generated by the gate current through the first auxiliary coil 310 and by the gate currents through the second auxiliary coil 320 are at least approximately equal in magnitude.

FIG. 6 shows a further switching assembly 900 that includes a first transistor 110 with a first gate terminal G1, a second transistor 120 with a second gate terminal G2, and a third transistor 130 with a third gate terminal G3. A first coil 211 is electrically connected between the first gate terminal G1 and the common gate structure GC. A second coil 212 is electrically connected between the second gate terminal G2 and the common gate structure GC. A first auxiliary coil 310 is electrically connected between the third gate terminal G3 and the common gate structure GC. The first gate terminal G1, the second gate terminal G2, and the third gate terminal G3 simultaneously receive a common gate signal through the common gate structure GC.

A winding of the first coil 211 is wound around a first leg of a multi-leg transformer core 255 with three legs. A winding of the second coil 212 is wound around a second leg of the multi-leg transformer core 255. A winding of the first auxiliary coil 310 is wound around a third leg of the multi-leg transformer core 255. The winding directions are selected such that the first coil 211 is inversely inductively coupled with a second gate current flowing between the common gate structure GC and the second gate terminal G2 and with a third gate current flowing between the common gate structure GC and the third gate terminal G3, the second coil 212 is inversely inductively coupled with a first gate current flowing between the common gate structure GC and the first gate terminal G1 and with a third gate current flowing between the common gate structure GC and the third gate terminal G3, and the first auxiliary coil 310 is inversely inductively coupled with a first gate current flowing between the common gate structure GC and the first gate terminal G1 and with a second gate current flowing between the common gate structure GC and the second gate terminal G2. In other words, the two coils of each pair of the first coil 211, the second coil 212, and the first auxiliary coil 310 are inversely inductively coupled with reference to a current supplied through the common gate structure GC.

The windings of the first coil 211, the second coil 212, and the first auxiliary coil 310 have the same number of turns.

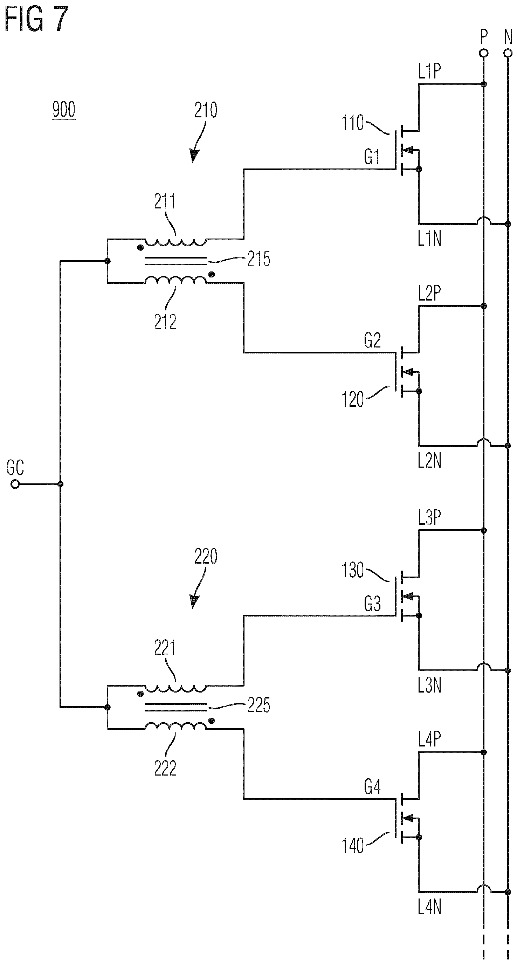

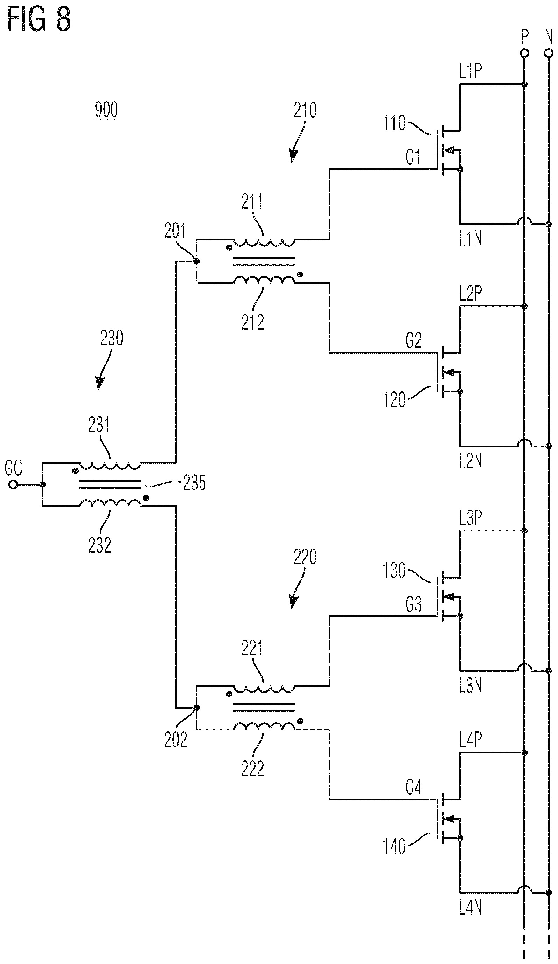

FIG. 7 and FIG. 8 show further switching assemblies 900 that include a first transistor 110 with a first gate terminal G1, a second transistor 120 with a second gate terminal G2, a third transistor 130 with a third gate terminal G3, and a fourth transistor 140 with a fourth gate terminal G4. A first coil 211 is electrically connected between the first gate terminal G1 and the common gate structure GC. A second coil 212 is electrically connected between the second gate terminal G2 and the common gate structure GC. A third coil 221 is electrically connected between the third gate terminal G3 and the common gate structure GC. A fourth coil 222 is electrically connected between the fourth gate terminal G4 and the common gate structure GC. The first gate terminal G1, the second gate terminal G2, the third gate terminal G3, and the fourth gate terminal G4 simultaneously receive a common gate signal through the common gate structure GC.

The first coil 211 and the second coil 212 are inversely inductively coupled with reference to a current supplied through the common gate structure GC. The third coil 221 and the fourth coil 222 are inversely inductively coupled with reference to a current supplied through the common gate structure GC.

The windings of the first coil 211 and the second coil 212 can be wound around a first transformer core 215 in opposite winding directions. Alternatively, the first coil 211 and the second coil 212 may form a coreless first transformer 210. The windings of the third coil 221 and the fourth coil 222 are wound around a second transformer core 225 in opposite winding directions. Alternatively, the third coil 221 and the fourth coil 222 may form a coreless second transformer 220.

The first transformer core 215 and the second transformer core 225 can have the same shape and dimensions and can be formed from the same material. The windings of the first coil 211, the second coil 212, the third coil 221 and the fourth coil 222 may have the same number of turns.

The third coil 221 and the fourth coil 222 allow to detune, in addition to the parasitic oscillation system formed by the electrical loop including current paths through the first transistor 110 and the second transistor 120, at least one further parasitic oscillation system that includes current paths through the third transistor 130 and the fourth transistor 140.

In FIG. 7, the windings of the first coil 211, the second coil 212, the third coil 221 and the fourth coil 222 are directly electrically connected to the common gate structure GC.

In FIG. 8, a fifth coil 231 is electrically connected between the common gate structure GC and a first network node 201 connected to the first coil 211 and the second coil 212, and a sixth coil 232 is electrically connected between the common gate structure GC and a second network node 202 connected to the third coil 221 and the fourth coil 222. The fifth coil 231 and the sixth coil 232 are inversely inductively coupled with reference to a current supplied through the common gate structure GC.

The windings of the fifth coil 231 and the sixth coil 232 may have the same number of turns. The windings of the fifth coil 231 and the sixth coil 232 can be wound around a pre-stage transformer core 235 in opposite winding directions. Alternatively, the fifth coil 231 and the sixth coil 232 may form a coreless pre-stage transformer 230.

The first transformer core 215, the second transformer core 225, and the pre-stage transformer core 235 may have the same shape and dimensions and can be formed from the same material.

The fifth coil 231 and the sixth coil 232 allow to detune, in addition to the parasitic oscillation systems formed by the each of the electrical loops with current paths through the first transistor 110 and the second transistor 120 or with current paths through the third transistor 130 and the fourth transistor 140, a further parasitic oscillation system that includes a current path through at least one of the first and second transistors 110, 120 and at least one of the third and fourth transistors 130, 140.

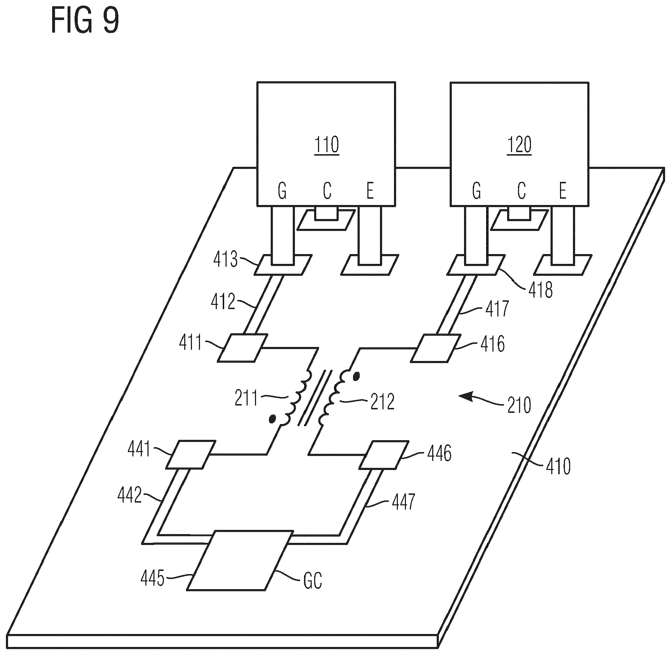

FIG. 9 shows a first carrier substrate 410. The first transistor 110 and the second transistor 120 are mounted on the first carrier substrate 410.

A first coil conductor line 442 directly connects a common gate pad 445 with a first coil input pad 441. A second coil conductor line 447 directly connects the common gate pad 445 with a second coil input pad 446. A first gate conductor line 412 connects a first gate input pad 411 and a first transistor gate pad or through hole via 413. A second gate conductor line 417 connects a second gate input pad 416 and a second transistor gate pad or through hole via 418.

A transformer 210 that includes a first coil 211 and a second coil 212 is mounted on the first carrier substrate 410. A winding of the first coil 211 is electrically connected between the first coil input pad 441 and the first gate input pad 411 directly or through bonding wires. A winding of the second coil 212 is electrically connected between the second coil input pad 446 and the second gate input pad 416 directly or through bonding wires.

The first coil 211 and the second coil 212 may include windings with each turn formed by conductor lines in a wiring plane of the first carrier substrate 410. Alternatively, the first transformer 210 is a discrete device mounted on the first carrier substrate 410. In addition to the first and second coils 110, 120, the first transformer 210 can include a transformer core around which the windings of the first coil 110 and the second coil 120 are wound.

Packages of the first transistor 110 and the second transistor 120 include separated leads, e.g., a gate lead G, an emitter lead E, and a collector lead C. The first carrier substrate 410 may be a PCB or a DBC substrate. Load paths of the first transistor 110 and the second transistor 120 are electrically connected in parallel to each other. The gate lead G of the first transistor 110 has a soldered connection to the first transistor gate pad or through hole via 413. The gate lead G of the second transistor 120 has a soldered connection to the second transistor gate pad or through hole via 418.

The first coil 211 and the second coil 212 form an oscillation-attenuating transformer preventing oscillations in a parasitic electrical loop that includes the wiring connections between the common gate pad 445 and the gate leads G of the first and second transistors 110, 120, the gate-to-emitter paths of the first and second transistors 110, 120, and a part of a conductor line connecting the emitter leads E of the first and second transistors 110, 120.

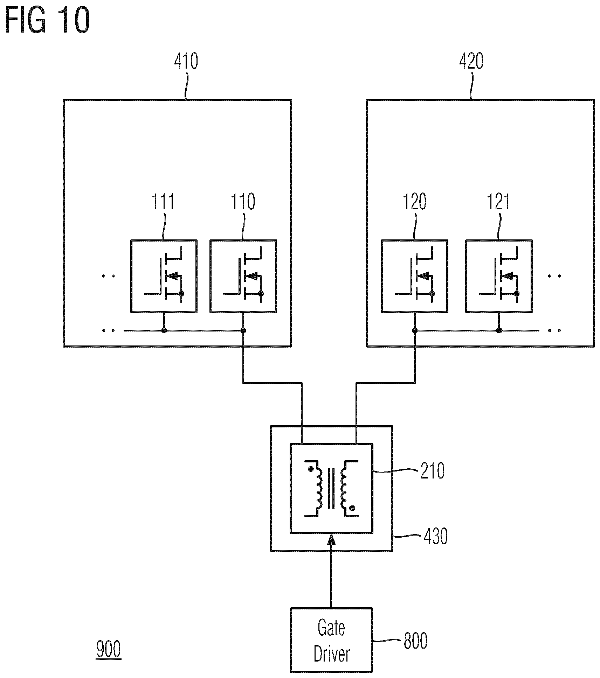

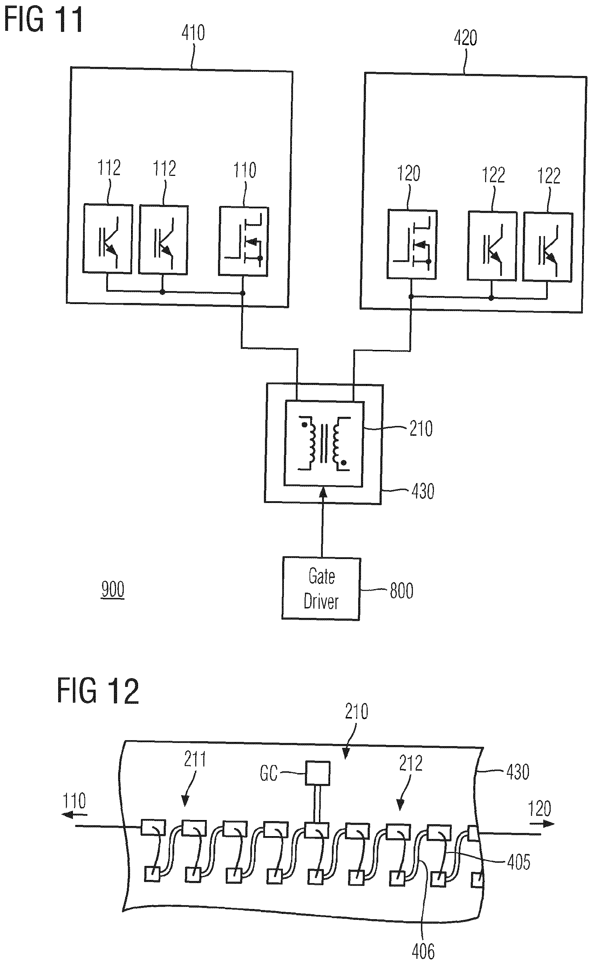

FIG. 10 and FIG. 11 show switching assemblies 900 with a first carrier substrate 410 and a second carrier substrate 420. The first transistor 110 may be mounted on the first carrier substrate 410 and the second transistor 120 may be mounted on the second carrier substrate 420.

One or more further transistors with controlled load paths electrically connected in parallel to the controlled load path of the first transistor 110 can be mounted on the first carrier substrate 410. One or more further transistors with controlled load paths electrically connected in parallel to the controlled load path of the second transistor 120 can be mounted on the second carrier substrate 420.

In FIG. 10, additional transistors 111 with controlled load paths electrically connected in parallel to the first transistor 110 on the first carrier substrate 410 have the same type and at least approximately the same switching characteristics as the first transistor 110, and additional transistors 121 with controlled load paths electrically connected in parallel to the second transistor 120 on the second carrier substrate 420 have the same type and at least approximately the same switching characteristics as the second transistor 120.

In FIG. 11, additional transistors 112 with controlled load paths electrically connected in parallel to the first transistor 110 on the first carrier substrate 410 have a type and switching characteristics different from the first transistor 110, and additional transistors 122 with controlled load paths electrically connected in parallel to the second transistor 120 on the second carrier substrate 420 have a type and switching characteristics different from the second transistor 120. For example, the first and second transistors 110, 120 can be silicon carbide MOSFETs and the additional transistors 112, 122 can be silicon IGBTs.

A transformer 210 as described above is mounted on an auxiliary substrate 430. Alternatively, the transformer 210 may be mounted on the first carrier substrate 410 or the second carrier substrate 420.

The auxiliary substrate 430 is separated from the first carrier substrate 410 and the second carrier substrate 420. The auxiliary substrate 430 may include pins for connecting the auxiliary substrate 430 mechanically and/or electrically with another substrate, e.g., the first carrier substrate 410 or the second carrier substrate 420. Alternatively, the auxiliary substrate 430 may include bonding pads adapted for wire bonding.

The switching assemblies 900 further include a gate driver circuit 800. The gate driver circuit 800 can be mounted on the auxiliary substrate 430 or can be arranged separate from the auxiliary substrate 430. The gate driver circuit 800 outputs the common gate signal. The windings of the first coil 211 and the second coil 212 receive the common gate signal.

The transformer 210 can attenuate oscillations in a parasitic oscillating system that is formed by one or more of the gate loops on the first carrier substrate 410 in combination with one or more of the gate loops on the second carrier substrate 420.

FIG. 12 shows a coreless transformer 210 with a first coil 211 and a second coil 212 formed on an auxiliary substrate 430. A winding of the first coil 211 includes four turns, wherein each turn includes a first section formed by a conductor line 406 and a second section formed by a bonding wire 405, wherein the bonding wired 405 is bonded to an end of the conductor line 406. Accordingly, a winding of the second coil 212 includes four turns, wherein each turn includes a first section formed by a conductor line 406 and a second section formed by a bonding wire 405, and wherein the bonding wired 405 is bonded to an end of the conductor line 406.

## Claims

1. A switching assembly (900), comprising:
a common gate structure (GC);
a first transistor (110) comprising a first gate terminal (G1) ;
a second transistor (120) comprising a second gate terminal (G2);
a first coil (211) electrically connected between the first gate terminal (G1) and the common gate structure (GC); and
a second coil (212) electrically connected between the second gate terminal (G2) and the common gate structure (GC), wherein the first coil (211) and the second coil (212) are inversely inductively coupled with reference to a current supplied through the common gate structure (GC).

2. The switching assembly according to claim 1, further comprising:
a transformer core (215), wherein the first coil (211) and the second coil (212) are wound around the transformer core (215) in opposite winding directions.

3. The switching assembly according to any of claims 1 and 2, further comprising:
a third transistor (130) comprising a third gate terminal (G3) configured to receive a gate signal through the common gate structure (GC).

4. The switching assembly according to claim 3, further comprising:
a first auxiliary coil (310) electrically connected between the third gate terminal (G3) and the common gate structure (GC), wherein the first auxiliary coil (310) is inductively coupled with a first gate current flowing between the common gate structure (GC) and the first gate terminal (G1) and with a second gate current flowing between the common gate structure and the second gate terminal (G2).

5. The switching assembly according to claim 3, further comprising:
an auxiliary transformer (300) comprising a first auxiliary coil (310) and a second auxiliary coil (320), wherein the first auxiliary coil (310) is electrically connected between the third gate terminal (G3) and the common gate structure (GC), wherein the second auxiliary coil (320) is electrically connected between the common gate structure (GC) and the first and second coils (110, 120), and wherein the first auxiliary coil (310) and the second auxiliary coil (320) are inversely inductively coupled with reference to a current supplied through the common gate structure (GC).

6. The switching assembly according to claim 5,
wherein a winding ratio between the first auxiliary coil (310) and the second auxiliary coil (320) is in a range from 1,9:1 to 2,1:1.

7. The switching assembly according to claim 3, further comprising:
a first auxiliary coil (310) electrically connected between the third gate terminal (G3) and the common gate structure (GC); and
a multi-leg transformer core (255) inversely inductively coupling the first auxiliary coil (310) with a first gate current flowing between the common gate structure (GC) and the first gate terminal (G1) and with a second gate current flowing between the common gate structure and the second gate terminal (G2).

8. The switching assembly according to claim 3, further comprising:
a multi-leg transformer core (255) comprising a first leg, a second leg, and a third leg, wherein the first coil (211) is wound around the first leg, the second coil (212) is wound around the second leg, a first auxiliary coil (310) is wound around the third leg, and wherein coils of each pair of the first coil (211), the second coil (212), and the first auxiliary coil (310) are inversely inductively coupled with reference to a current supplied through the common gate structure (GC).

9. The switching assembly according to any of claims 1 and 2, further comprising:
a third transistor (130) comprising a third gate terminal (G3) ;
a fourth transistor (140) comprising a fourth gate terminal (G4) ;
a third coil (221) electrically connected between the third gate terminal (G3) and the common gate structure (GC);
a fourth coil (222) electrically connected between the fourth gate terminal (G4) and the common gate structure (GC), wherein the third coil (221) and the fourth coil (222) are inversely inductively coupled with reference to a current supplied through the common gate structure (GC).

10. The switching assembly according to claim 9, further comprising:
a fifth coil (231) electrically connected between the common gate structure (GC) and a first network node (201) connected to the first coil (211) and the second coil (212) ;
a sixth coil (232) electrically connected between the common gate structure (GC) and a second network node (202) connected to the third coil (221) and the fourth coil (222), wherein the fifth coil (231) and the sixth coil (232) are inversely inductively coupled with reference to a current supplied through the common gate structure (GC) .

11. The switching assembly according to any of claims 1 to 10, further comprising:
a first carrier substrate (410), wherein the first transistor (110) and the second transistor (120) are mounted on the first carrier substrate (410).

12. The switching assembly according to claim 11,
wherein the first coil (211) and the second coil (211) are mounted on the first carrier substrate (410) and/or comprise at least one turn formed by conductor lines in a wiring plane of the first carrier substrate (410).

13. The switching assembly according to any of claims 1 to 10, further comprising:
a second carrier substrate (420), wherein the first transistor (110) is mounted on the first carrier substrate (410) and the second transistor (120) is mounted on the second carrier substrate (420).

14. The switching assembly according to any of claims 1 to 10 and 13,
wherein the first coil (110) and the second coil (120) are mounted on an auxiliary substrate (450).

15. The switching assembly according to any of the preceding claims,
wherein at least the first coil (110) includes at least one section formed by a bonding wire (405).
